(19) Europäisches Patentamt
European Patent Office
Office européen des brevets

(11) **EP 4 095 534 B1**

(12) **EUROPEAN PATENT SPECIFICATION**

(45) Date of publication and mention
of the grant of the patent:
**17.07.2024 Bulletin 2024/29**

(21) Application number: **21176160.6**

(22) Date of filing: **27.05.2021**

(51) International Patent Classification (IPC):
**G01R 31/28** (2006.01) **G01R 15/18** (2006.01)
**G01R 31/315** (2006.01) **H01F 17/00** (2006.01)
**H01F 5/00** (2006.01)

(52) Cooperative Patent Classification (CPC):
**G01R 31/2853; G01R 15/18; G01R 31/315;
H01F 5/003**

(54) **SEMICONDUCTOR ASSEMBLY, ELECTRIC POWER DEVICE AND METHOD OF MANUFACTURING**

HALBLEITERANORDNUNG, ELEKTRISCHE LEISTUNGSVORRICHTUNG UND VERFAHREN ZUR HERSTELLUNG

ENSEMBLE SEMI-CONDUCTEUR, DISPOSITIF D'ALIMENTATION ÉLECTRIQUE ET SON PROCÉDÉ DE FABRICATION

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**30.11.2022 Bulletin 2022/48**

(73) Proprietor: **Hitachi Energy Ltd
8050 Zürich (CH)**

(72) Inventors:
• **SCHUDERER, Jürgen
8047 Zürich (CH)**

• **SCHROEDER, Arne
3012 Bern (CH)**

(74) Representative: **Epping - Hermann - Fischer
Patentanwaltsgesellschaft mbH
Schloßschmidstraße 5
80639 München (DE)**

(56) References cited:
**US-A1- 2001 023 530    US-A1- 2003 013 264
US-A1- 2007 114 992    US-A1- 2015 028 487
US-A1- 2016 327 592    US-A1- 2017 271 260**

**Description**

The present disclosure relates to assemblies allowing load current sensing, e.g. for chip-scale packages, e.g. for chip-scale packages including power semiconductors, and to corresponding electric devices.

It is desired to know a load current or phase current of an electric device, e.g. of a power converter, e.g. to realize a closed loop control of the power conversion functionality.

In conventional inverters, e.g. for automotive use, and other applications, Hall-effect-sensors are used. The sensors are mounted around the phase outputs and are a limiting factor in cost and construction volume.

It is further possible to replace Hall sensors with power module on-board shunt resistors. However, shunt resistors have high ohmic losses involved when generating a sensor output in the Volt range required for further signal processing.

Another approach is based on integrating a current mirror on-chip. However, sacrificing a fraction of the active area for installing a parallel path for current sensing increases on-state resistance and reduces bond pad area on the topside. In addition, when considering SiC (silicon carbide) devices with very expensive chip area, the on-chip solution becomes expensive.

From EP 3012846 A1 printed circuit boards with an inductance element are known. From US 2017/271260 A1 semiconductor assemblies including a semiconductor chip and a passive circuit element are known. From US 2001/023530 A1 inductive elements consisting of a plurality of interconnected conducted segments integrated in a substrate are known. From US 2003/013264 A1 inductors for sensing a magnetic flux are known. From US 2015/028487 A1 semiconductor elements and sensing coils are known.

Thus, embodiments of the disclosure relate to the possibility to sense a load current or phase current of an electric device, e.g. of a power converter. It would be beneficial if a closed loop control of a power conversion functionality could be realized in a simple and efficient manner with such a sensing. Further, the solution may be compatible with power modules. Further, the solution may require minimum costs and space. Also, the solution may be with a small capacitive coupling and allow low or no common-mode distortions, e.g. when sensing fast switching devices.

To that end, a semiconductor assembly and a method of manufacturing a semiconductor assembly according to the independent claims are provided, which also define the invention. Dependent claims provide preferred embodiments.

In the following, portions of the description and drawings relating to embodiments not covered by the claims are not presented as embodiments of the invention, but as examples useful in understanding the invention.

The semiconductor assembly comprises a body with a bottom side and a top side and a vertical extension from the bottom side and the top side. Further, the semiconductor assembly comprises a semiconductor element arranged in the body and a sensing coil arranged in the body. The sensing coil has at least one winding. The sensing coil is provided and adapted such that a magnetic flux associated with an electric current propagating along a current path in a vertical direction causes a detectable voltage in the sensing coil.

Such a semiconductor assembly allows - via its sensing coil, e.g. when directly integrated in the body, via and surrounding the current path associated with the semiconductor element - sensing a load current or phase current of the semiconductor element, e.g. to realize a closed loop control without the need for cost intensive and area and volume consuming further elements such as hall sensors or other external circuitry. Such a semiconductor assembly allows generating a sensor output in the Volt range required for further signal processing. Further, the semiconductor assembly can be realized in a simple and efficient manner involving essentially no further costs or space consumption. Further, the semiconductor assembly is compatible with power applications. Further, the semiconductor assembly allows for a small capacitive coupling and a substantial reduction of common-mode distortions making it a suitable for fast switching devices.

In the semiconductor assembly the at least one winding is arranged in a plane parallel to the vertical direction. The semiconductor assembly is a chip-scale package or a chip-scale-like package.

In this respect, a chip-scale package is a package with a single semiconductor chip and where the footprint or volume of the package may not be larger than 200 percent of the footprint or volume of the chip. It is also possible that the package may not be larger than 150% or even 120% of the footprint or volume of the chip.

Correspondingly, the semiconductor assembly can further comprise one or more additional semiconductor elements in the form of the semiconductor element such that the semiconductor assembly is a multi-chip chip-scale-like package or a multi-chip module.

In this respect, a multi-chip module is a module comprising the semiconductor element and one or more additional chips or elements such as an additional semiconductor element. The one or more additional chips or elements can be directly or monolithically integrated in the body of the semiconductor assembly.

Correspondingly, a multi-chip chip-scale-like package is a multi-chip module where the footprint or volume of the package may not be larger than 200 percent of sum of the footprints or volumes of the individual chips or elements. It is also possible that the package may not be larger than 150% or even 120% of the footprint or volume of the chip.

In the semiconductor assembly the semiconductor element and the at least one winding can be directly integrated in a dielectric material.

In the semiconductor assembly the dielectric material can comprise one or two or more segments or layers, each segment or layer comprising or consisting of a material or a combination of materials selected from a PCB material, a mold material, a thermoplastic material, epoxy resin, FR-2, phenolic paper, phenolic cotton paper, paper impregnated with a phenol formaldehyde resin, FR-4, a woven fiberglass cloth impregnated with an epoxy resin, a polyimide, a polyimide-fluoropolymer, a polyimide-fluoropolymer composite, FR-1, FR-3, FR-5, woven fiberglass, high strength at higher temperatures, FR-6, G-10, G-11, CEM-1, CEM-2, CEM-3, CEM-4, CEM-5, PTFE, RF-35, a ceramic, Alumina.

In this respect, a layer has - except structured metallizations, vias and circuit elements - body material essentially homogeneous over the lateral area of the semiconductor assembly. Segments of different body material can be arranged one next to another in a given vertical height of the body. Thus, the body can comprise different layers to fully enclose and directly integrate the semiconductor chip in the body. Between different layers structured metallizations for redistributing power or signals can be arranged. Within the layers vias can be arranged to electrically connect the semiconductor element, the structured metallizations and contacts for connecting the semiconductor assembly to an external circuit environment.

The semiconductor assembly can comprise one or more further sensing coils in form of the sensing coil. The one or more further sensing coils can be provided and adapted such that a magnetic flux associated with a time varying electric current propagating in the vertical direction causes a detectable voltage in the one or more further sensing coils.

When more than one sensing coil is present then the one or more sensing coils can be electrically connected in series to increase the induced voltage to improve the signal-to-noise ratio.

In the body of the semiconductor assembly the sensing coil can comprise lateral metallization structures and vertical vias.

In the semiconductor assembly the vertical vias can electrically connect lateral metallization structures such that one, two or more segments or layers of the dielectric material are arranged between the lateral metallization structures.

In the semiconductor assembly the sensing coil is a helical coil arranged along a path laterally surrounding the current path.

The semiconductor assembly can further comprise a compensation coil with a compensating winding for each winding of the sensing coil. The compensating coil can be provided and adapted to compensate a common mode distortion of the sensing coil.

The sensing coil and the compensation coil can establish a differential sensing structure.

The semiconductor assembly can further comprise a second current path in the negative vertical direction -z and an auxiliary coil adapted and provided such that a magnetic flux associated with an electric current propagating along the second current path in the negative vertical direction causes a detectable voltage in the auxiliary coil.

In the semiconductor assembly the current path in the vertical direction can comprise sections electrically connected in parallel.

In the semiconductor assembly the semiconductor element can be a semiconductor for power electronics applications.

In the semiconductor assembly the semiconductor element can be a bipolar transistor, e.g., an IGBT (insulated gate bipolar transistor), or a field-effect transistor (FET) such as a low on-resistance silicon carbide MOSFET (Metal Oxide Semiconductor-FET) or a MISFET (Metal Insulating Semiconductor-FET), exemplarily with low on-resistance.

The semiconductor assembly can further comprise contacts provided and adapted for a connection to an external circuit environment. The contacts can be distributed over the top side and the bottom side of the semiconductor assembly. Or the contacts can be arranged at the top side of the semiconductor assembly. Or the contacts arranged at the bottom side of the semiconductor assembly.

A corresponding electric power device can comprise such a semiconductor assembly as described above. The device can be applied in power electronics converters. An example may be an automotive traction inverter.

The electric power device can further comprise an integrating circuit coupled to the sensing coil. The voltage sensed by the sensing coil can be proportional to the temporal derivation of the current propagating along the current path. Thus, an integration of the sensed voltage over time can yield a signal proportional to the load current.

The electric power device or its semiconductor assembly can exemplarily be used for phase current sensing, fault current detection, static current imbalance assessment, dynamic current imbalance assessment, current control and/or current monitoring.

The sensing coil surrounds the current propagation path in the horizontal x-y-plane.

Then, the induced voltage can be calculated according to equation (1):

$$(t) = -(AN\mu_0/l) * dI(t)/dt, \qquad\qquad (1)$$

V(t) is the sensed voltage signal of the sensing coil, A is the winding area, N is the number of windings, I is the length of the coil, and dI/dt(t) is the current transient inside the coil.

As an example, an output voltage of 1.26 V can be obtained for 40 loops of a rectangular cross section of 1.0 x 0.1 mm$^2$ with 1 mm distance with a coil length of 4 cm and a switching transient of dI/dt = 10 A/ns. Reducing the distance between windings to 0.1 mm (i.e. stacking the windings with a higher density) would result into 400 loops and an output voltage of 12.6 V.

A method of manufacturing a corresponding semiconductor assembly can comprise the steps of

- providing a semiconductor element,
- embedding the semiconductor element in one or more layers of dielectric material.

The method also comprises steps for creating first lateral and vertical structured metallizations, e.g. for redistributing power and/or signals.

Furthermore, the method also comprises, among other steps, creating lateral and vertical structured metallizations to establish windings of a sensing coil. For the creation of the structured metallizations of the sensing coil and for the creation of other structured metallizations the same steps, processes and materials can be used. In this respect, the method is defined by the independent claim 17.

The accompanying figures are included to provide a further understanding. In the figures, elements of the same structure and/or functionality may be referenced by the same reference signs. It is to be understood that the embodiments shown in the figures are illustrative representations and are not necessarily drawn to scale.

In the figures:

Fig. 1 shows elements of the semiconductor assembly illustrating details of the working principle.

Fig. 2 shows details of a cross section of a semiconductor assembly.

Fig. 3 shows details of a top side of a semiconductor assembly.

Fig. 4 shows a segment of an isolated sensing coil in an enlarged perspective view.

Fig. 5 shows the principle of compensating common mode distortions.

Fig. 6 shows details of a semiconductor assembly wherein the vertical height of the sensing coils essentially equals the vertical height of the semiconductor assembly.

Fig. 7 shows details of a semiconductor assembly wherein external contacts are arranged on a common side.

Fig. 8 shows a cross section corresponding to fig. 7.

Fig. 9 shows a top view onto a semiconductor assembly with three nested sensing coils.

Fig. 10 shows a top view onto a multi-chip-module.

Fig. 11 shows the use of an integrating circuit.

Fig. 12 shows the possibility of the provision of a return line of the coil that minimizes spurious coupling from non-wanted magnetic fields.

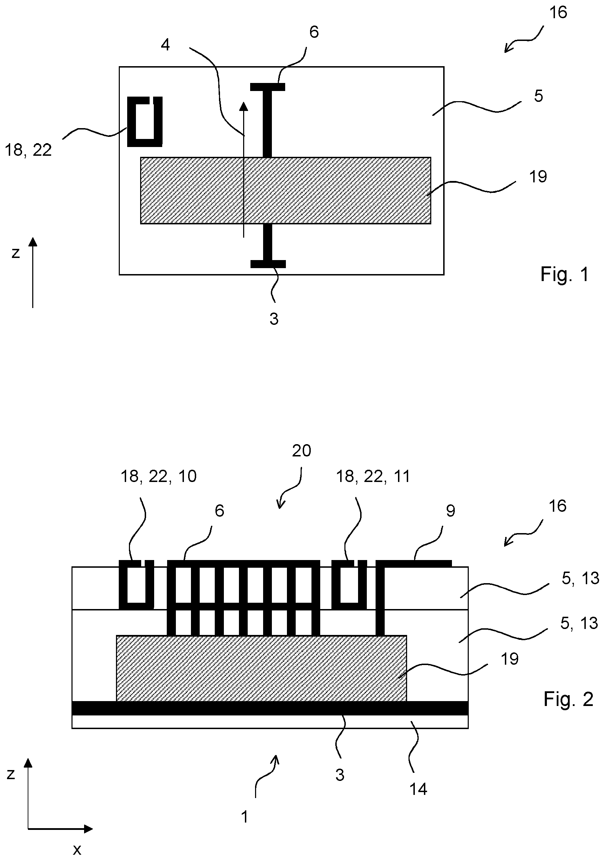

Figure 1 shows a semiconductor assembly 16 with a semiconductor element 19 directly integrated in a dielectric material 5. The semiconductor element has a direction of the current through the semiconductor element in a vertical direction z. A current in the vertical direction z generates a magnetic field surrounding the current propagation path. To obtain information regarding the current a winding 22 of the sensing coil 18 is arranged such that the magnetic flux associated with the current is captured. Thus, the winding has a normal essentially parallel the direction of the magnetic at the position of the winding.

A change of current corresponds to a change of magnetic flux through the coil and a change of magnetic flux corresponds to a voltage induction in the coil. By evaluating the voltage, e.g. via integration, sensing information can be obtained to precisely monitor the current associated with the current path, i.e. with the semiconductor element.

Of course, the number on windings of the coil is not limited to one. The number of windings can be between 1 and 1000, e.g. between 200 and 500.

The voltage induced is proportional to the flux for each winding. The total sensed voltage is the sum of the voltage contribution provided by each winding of the coil. Thus, by appropriately selecting the number of windings and by appropriately locating each winding at a corresponding position of magnetic field strength, the total sensing voltage for a given current-changing rate can be adjusted to match a given specification.

The semiconductor element can be an IGBT having an emitter 6 and a collector 3 or a MOSFET with a source and a drain contact or a MISFET. Thus, the current-changes between emitter and collector can be precisely determined even for high frequency applications.

The windings of the coil can be realized as structured metallizations. The windings can be comprised of vertical and horizontal sections. Vertical sections have an extensions along the vertical direction z. Horizontal sections can have extensions in the horizontal x-y plane.

Vertical sections can be realized as vias vertically penetrating through a layer 13 or a section of the dielectric material of the body.

Horizontal sections can be realized as structured metallizations vertically arranged between different layers or sections of the dielectric material or at the top side 20 or bottom side 1 of the body.

As the structuring of such horizontal or vertical connection structures may be necessary for electrical connections to and from the semiconductor element, e.g. for establishing a redistribution layer 13 or the like, the creation of the coil does not need any further steps during manufacturing and the direct integration can be performed essentially without the need for additional volume or footprint.

Figure 2 shows a semiconductor assembly design where the semiconductor assembly establishes a chip-scale-package. The sensing coil is simultaneously created during manufacturing by embedding processes of lamination, via drilling, and metallization by via filling and formation of redistribution layers.

The electronic device is bonded with its collector 3 contact to a lead frame 14, embedded in a PCB laminate or mold compound and contacted by Copper (Cu) vias. In a second laminate or mold compound layer 13, the semiconductor element interconnect vias are prolonged to the top side and redistributed to Gate 9 and Emitter 6 contact pads. In addition, the sensing coil realized as a helical coil is added around the Emitter load current vias by further vias and redistribution lines as structured metallizations that are terminated by two current sense contact pads 10 and 11 on the top side. All vias and redistribution s are manufactured in an automated PCB manufacturing equipment via drilling, sputtering and electroplating.

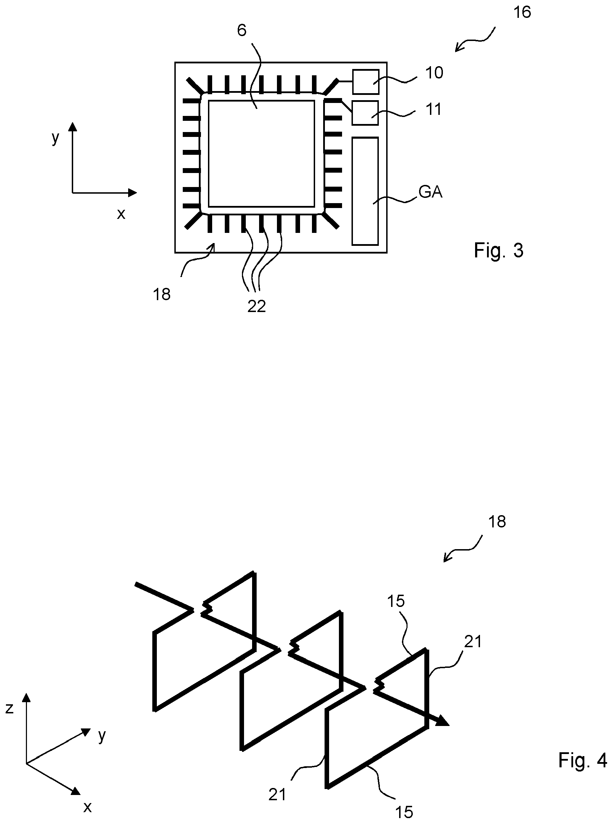

Figure 3 illustrates a top view onto the semiconductor assembly of figure 2. The sensing coil has a plurality of windings 22 and the sensing coil horizontally surrounds - in the x-y-plane - the vertical current path.

On the top side of the semiconductor assembly the emitter side contact 6 and the gate 9 contact are arranged. Further, the two connections to the coil 10 and 11 are arranged on the top side of the semiconductor assembly.

Figure 4 shows an enlarged perspective view of three windings 22 of the sensing coil 18 isolated for better illustration. The sensing coil's structured metallizations are created during manufacturing simultaneously with other structured metallizations created in the embedding processes.

In addition, fig. 4 shows the sensing coil realized as helical coil comprising vertical vias 21 and lateral metallization structures 15.

It is possible that each winding 22 of the coil has the structured metallizations essentially arranged is a plane parallel to the vertical direction z, except small sections dedicated to electrically connect a neighboring winding needed to prevent a short circuit of the winding 22.

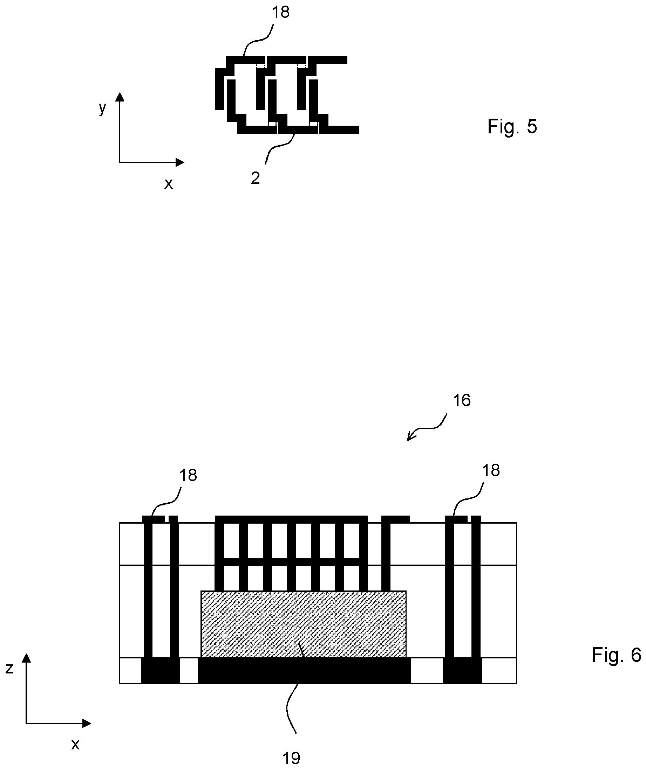

Figure 5 illustrates the principle of reducing or eliminating common-mode distortion utilizing a compensation coil 2 in addition to the sensing coil 18. The compensating coil 2 and the sensing coil are arranged such that for each winding of the sensing coil there is a winding of the compensating coil essentially overlapping with the winding of the sensing coil. The sensing coil and the compensating coil are electrically connected to one another such that their induced sensing voltages are with a phase shift of 180 degrees added and common-mode distortions are compensated. Thus, a balanced signal conduction is obtained and the unbalanced common-mode distortions are essentially eliminated.

This configuration of a compensating coil 2 in addition to the sensing coil 2 can also reduce the capacitive coupling, e.g. when sensing fast switching devices, a differential Rogowski coil as depicted in Fig. 3 can be used.

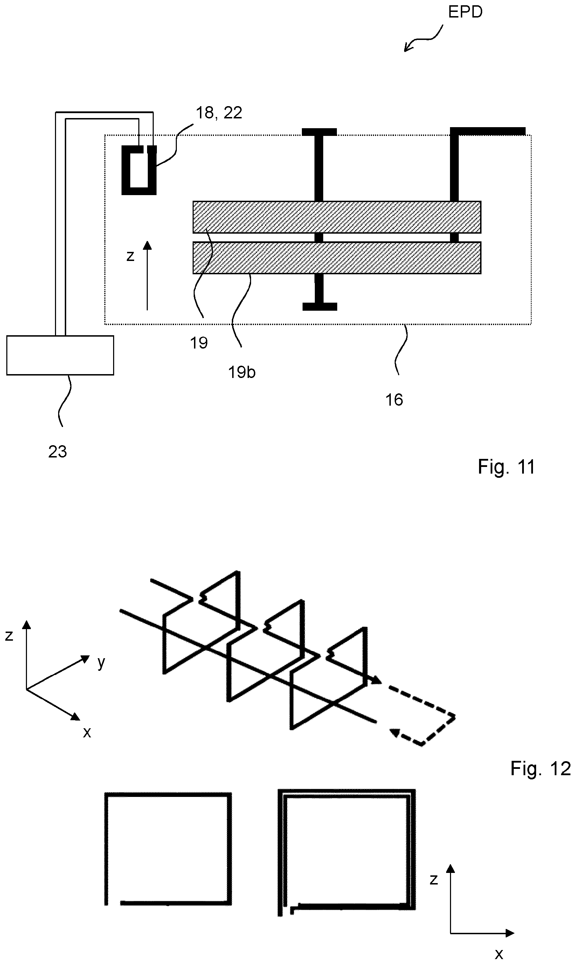

Figure 12 shows the possibility of the provision of a return line of the coil that minimizes spurious coupling from non-wanted magnetic fields in a perspective view (top portion of fig. 12) and in a view onto the x-z plane (bottom portion of fig. 12).

Figure 6 shows a variant of figure 2. In the semiconductor assembly according to figure 6 the windings of the sensing coil 18 has a vertical extension reaching from the top side of the semiconductor assembly 16 to the bottom side of the semiconductor assembly. Thus, the area of each winding is increased. Thus, the flux is increased. Thus, the sensed voltage is increased. Thus, the signal-to-noise ratio is improved.

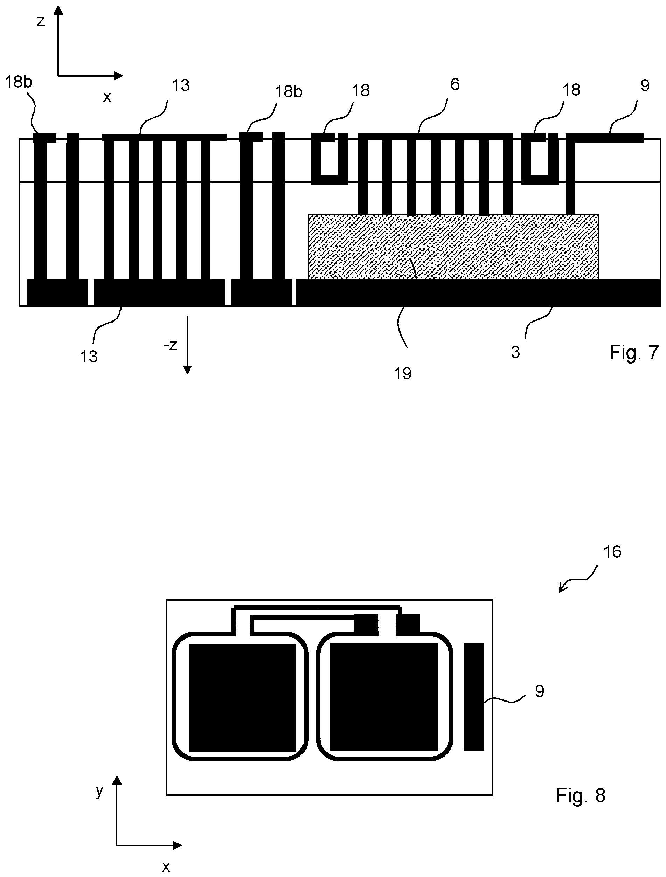

Figure 7 shows the possibility of arranging the connections of the semiconductor assembly 16 to an external circuit environment on the top side. To that end, vias arranged next to the semiconductor element 19 electrically connecting the collector-side connection 3 at the bottom side of the semiconductor assembly to corresponding top side connections are provided.

Thus, there is provided another vertical current path with the current direction opposed to the current direction directly via the semiconductor element. Thus, there is another possibility to utilize the sensing principle with a directly integrated sensing coil.

Correspondingly, the semiconductor assembly shown in figure 7 has a further sensing coil 18b surrounding - in the lateral x-y plane - the opposed direction current path.

Hereby it is important that the further sensing coil 18b is insulated from the collector potential. This can be obtained by providing a structured lead frame (not shown), e.g. by a pick & place process of Cu lead frames on a release film during manufacturing.

Compared to the sensing coil 18 arranged above the semiconductor element, the loop height of the further sensing coil 18b can be increased, e.g., from 0.1 to 0.3 mm, leading to a 3 times higher voltage signal.

Figure 8 shows the possibility of electrically connecting the sensing coil 18 of figure 7 in series to the further sensing coil 18b in order to obtain a higher (i.e. added) sensing voltage.

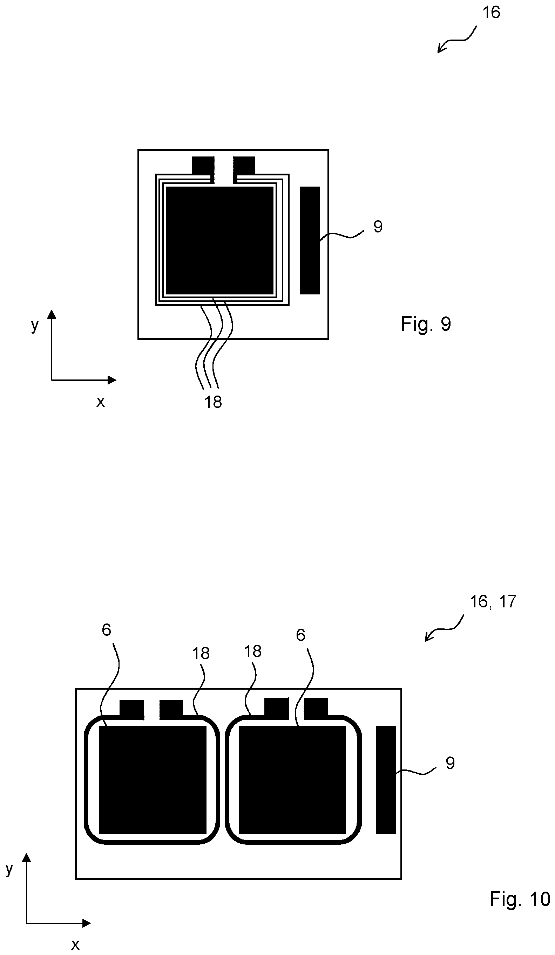

Similarly, figure 9 shows the possibility of providing more than one (e.g. three) sensing coil 18 surrounding the same vertical current path. This allows increased signal quality and the redundancy allows increased reliability.

Figure 10 shows the possibility - in a multi-chip module - to evaluate the current through a plurality of semiconducting elements in an element specific manner. Individually monitoring the trend of each semiconductor element allows identification of failing elements and the prediction of expected failures of each individual semiconductor element.

Figure 11 shows the possibility of providing an integrating circuit 23 to evaluate the derivative related sensed voltage (compare equation (1)).

The integrating circuit 12 can be directly integrated in the body of the semiconductor assembly. However, it is also possible that the integrating circuit is an element of an associated electric device comprising the semiconductor assembly and the integrating circuit as separate items, e.g. as shown in figure 11. Then the semiconductor assembly and the integrating circuit 12 can be arranged on a common carrier, e.g. a common printed circuit board.

Further, figure 11 shows the possibility of having an additional semiconductor element 19 arranged in the assembly.

List of reference signs

| | |
|---|---|
| 1: | bottom side |
| 2: | compensating coil |
| 3: | collector side contact |
| 4: | current path |
| 4b: | second current path |
| 5: | dielectric material |
| 6: | emitter side contact |
| 7: | electric power device |
| 9: | gate connection |
| 10, 11: | current sense contact pad |
| 12: | integrating circuit |
| 13: | layer |
| 14: | lead frame |
| 15: | lateral metallization structure |
| 16: | Semiconductor assembly |
| 17: | multi-chip module |
| 18: | sensing coil |
| 18b: | further sensing coil |
| 19: | semiconductor element |
| 19b: | additional semiconductor element |
| 20: | top side |
| 21: | vertical via |
| 22: | winding |
| 23: | integrating circuit |
| x, y: | lateral directions |
| z: | vertical direction |

**Claims**

1. A semiconductor assembly (16), comprising

   - a body with a bottom side (1) and a top side (20) and a vertical extension from the bottom side (1) and the top side (20)
   - a semiconductor element (19) arranged in the body,
   - a sensing coil (18) arranged in the body, the sensing coil having at least one winding (22),

   wherein

   - the sensing coil (18) is provided and adapted such that a magnetic flux associated with a time-varying electric current propagating along a current path in a vertical direction (z) causes a detectable voltage in the sensing coil (18), wherein said current path is associated with the semiconductor element (19),
   - the at least one winding (22) is arranged in a plane parallel to the vertical direction (z), **characterized in that**
   - the semiconductor assembly (16) is a chip-scale package or a chip-scale-like package or a multi-chip chip-scale package,
   - the footprint or volume of the package is not larger than 200 percent of the footprint or volume of the chip or not larger than 200 percent of the sum of the footprints or volumes of the individual chips,
   - the sensing coil (18) is a helical coil arranged along a path laterally surrounding the current path (4),
   - the sensing coil (18) horizontally surrounds the current path.

2. The semiconductor assembly (16) according to claim 1, further comprising one or more additional semiconductor elements (19b) in form of the semiconductor element (19) such that the semiconductor assembly (16) is a multi-chip chip-scale-like package.

3. The semiconductor assembly (16) according to any of the previous claims, wherein the semiconductor element (19) and the at least one winding (22) are directly integrated in a dielectric material (5).

4. The semiconductor assembly (16) according to claim 3, wherein the dielectric material (5) comprises one or two or more segments (S) or layers (13), each segment or layer comprising or consisting of a material or a combination of materials selected from a PCB material, a mold material, a thermoplastic material, epoxy resin, FR-2, phenolic paper, phenolic cotton paper, paper impregnated with a phenol formaldehyde resin, FR-4, a woven fiberglass cloth impregnated with an epoxy resin, a polyimide, a polyimide-fluoropolymer, a polyimide-fluoropolymer composite, FR-1, FR-3, FR-5, woven fiberglass, high strength at higher temperatures, FR-6, G-10, G-11, CEM-1, CEM-2, CEM-3, CEM-4, CEM-5, PTFE, RF-35, a ceramic, Alumina.

5. The semiconductor assembly (16) according to any of the previous claims, comprising one or more further sensing coils (18b) in form of the sensing coil (18), wherein the one or more further sensing coils are provided and adapted such that a magnetic flux associated with an electric current propagating in a vertical direction causes a detectable voltage in the one or more further sensing coils (18b).

6. The semiconductor assembly (16) according to claim 5, wherein the sensing coil (18) and the one or more further sensing coils (18b) are electrically connected in series.

7. The semiconductor assembly (16) according to any of the previous claims, wherein the sensing coil (18) comprises lateral metallization structures (15) and vertical vias (21).

8. The semiconductor assembly (16) according to claim 7, wherein the vertical vias (21) electrically connect lateral metallization structures (15) such that one, two or more segments (S) or layers (13) of the dielectric material (5) are arranged between the lateral metallization structures (15) .

9. The semiconductor assembly (16) according to any of the previous claims, further comprising

   - a compensation coil (2) with a compensating winding for each winding of the sensing coil, the compensating coil (2) being provided and adapted to compensate a common mode distortion of the sensing coil (18),

   wherein

- the sensing coil (18) and the compensation coil (2) establish a differential sensing structure (DSS).

10. The semiconductor assembly (16) according to any of the previous claims, further comprising a return line of the coil provided and adapted to minimize spurious coupling from non-wanted magnetic fields.

11. The semiconductor assembly (16) according to any of the previous claims, further comprising a second current path (4b) in the negative vertical direction (-z) and an auxiliary coil (AC) adapted and provided such that a magnetic flux associated with an electric current propagating along the second current path (4b) in the negative vertical direction causes a detectable voltage in the auxiliary coil (AC).

12. The semiconductor assembly (16) according to any of the previous claims, wherein the current path (4) in the vertical direction comprises sections electrically connected in parallel.

13. The semiconductor assembly (16) according to any of the previous claims, comprising contacts (6, 9, 3) provided and adapted for a connection to an external circuit environment, wherein the contacts (6, 9, 3) are

- distributed over the top side (20) and the bottom side (1) of the semiconductor assembly,
- arranged at the top side (20) of the semiconductor assembly (16) or
- arranged at the bottom side (1) of the semiconductor assembly (16).

14. An electric power device (7), comprising a semiconductor assembly (16) according to any of the previous claims, the device (7) being applied within a converter, a power electronics converter, or an automotive inverter.

15. The electric power device (7) according to claim 14, further comprising an integrating circuit (12) coupled to the sensing coil (18).

16. Use of the electric power device (7) according to any of claims 14 or 15 for at least one of: phase current sensing, fault current detection, static current imbalance assessment, dynamic current imbalance assessment, current control or current monitoring.

17. A method of manufacturing a semiconductor assembly (16) comprising the steps:

- providing a semiconductor element (19),
- embedding the semiconductor element (19) in one or more layers (13) of dielectric material (5),
- creating first lateral (15) and vertical (21) structured metallizations,
- creating lateral (15) and vertical (21) structured metallizations to establish windings (22) of a sensing coil (18), wherein the sensing coil (18) is provided and adapted such that a magnetic flux associated with a time-varying electric current propagating along a current path in a vertical direction (z) causes a detectable voltage in the sensing coil (18), wherein said current path is associated with the semiconductor element (19),

wherein

- for the creation of the structured metallizations (15, 21) of the sensing coil (18) and for the creation of the first structured metallizations (15, 21) the same steps, processes and materials are used,
- the windings (22) are arranged in a plane parallel to the vertical direction (z), **characterized in that**
- the semiconductor assembly (16) is a chip-scale package or a chip-scale-like package or a multi-chip chip-scale package,
- the footprint or volume of the package is not larger than 200 percent of the footprint or volume of the chip or not larger than 200 percent of the sum of the footprints or volumes of the individual chips,
- the sensing coil (18) is a helical coil arranged along a path laterally surrounding the current path (4),
- the sensing coil (18) horizontally surrounds the current path.

**Patentansprüche**

1. Halbleiteranordnung (16), die Folgendes umfasst:

- einen Grundkörper mit einer Unterseite (1) und einer Oberseite (20) und einer vertikalen Ausdehnung von der Unterseite (1) und der Oberseite (20)
- ein Halbleiterelement (19), das in dem Grundkörper angeordnet ist,
- eine im Grundkörper angeordnete Sensorspule (18), die mindestens eine Wicklung (22) aufweist,

wobei

- die Sensorspule (18) derart vorgesehen und angepasst ist, dass ein magnetischer Fluss, der mit einem zeitlich veränderlichen elektrischen Strom verbunden ist, der sich entlang eines Strompfades in einer vertikalen Richtung (z) ausbreitet, eine erfassbare Spannung in der Sensorspule (18) verursacht, wobei der Strompfad mit dem Halbleiterelement (19) verbunden ist,
- die mindestens eine Wicklung (22) in einer Ebene parallel zur vertikalen Richtung (z) angeordnet ist, **dadurch gekennzeichnet, dass**
- die Halbleiteranordnung (16) ein Chip - Scale - Package oder ein Chip-Scale-ähnliches Package oder ein Multichip-Chip-Scale-Package ist,
- die Grundfläche oder das Volumen des Package nicht größer ist als 200 Prozent der Grundfläche oder des Volumens des Chips oder nicht größer ist als 200 Prozent der Summe der Grundflächen oder Volumen der einzelnen Chips,
- die Sensorspule (18) eine spiralförmige Spule ist, die entlang eines Pfades angeordnet ist, der den Strompfad (4) seitlich umgibt,
- die Sensorspule (18) den Strompfad horizontal umgibt.

2. Halbleiteranordnung (16) nach Anspruch 1, ferner umfassend ein oder mehrere zusätzliche Halbleiterelemente (19b) in Form des Halbleiterelements (19), so dass die Halbleiteranordnung (16) ein Multichip-Chip-Scale-ähnliches Package ist.

3. Halbleiteranordnung (16) nach einem der vorhergehenden Ansprüche, wobei das Halbleiterelement (19) und die mindestens eine Wicklung (22) direkt in ein dielektrisches Material (5) integriert sind.

4. Halbleiteranordnung (16) nach Anspruch 3, wobei das dielektrische Material (5) ein oder zwei oder mehr Segmente (S) oder Schichten (13) umfasst, wobei jedes Segment oder jede Schicht ein Material oder eine Kombination von Materialien umfasst oder daraus besteht, das bzw. die ausgewählt ist aus einem PCB-Material, einem Formmaterial, einem thermoplastischen Material, Epoxidharz, FR-2, Phenolpapier, Phenolbaumwollpapier, mit einem Phenolformaldehydharz imprägniertem Papier,
FR-4, einem mit einem Epoxidharz imprägnierten Glasfasergewebe, einem Polyimid, einem Polyimid-Fluorpolymer, einem Polyimid-Fluorpolymer-Verbundstoff, FR-1, FR-3, FR-5, Glasfasergewebe, hohe Festigkeit bei höheren Temperaturen, FR-6, G-10, G-11, CEM-1, CEM-2, CEM-3, CEM-4, CEM-5, PTFE, RF-35, einer Keramik, Aluminiumoxid.

5. Halbleiteranordnung (16) nach einem der vorhergehenden Ansprüche, die eine oder mehrere weitere Sensorspulen (18b) in Form der Sensorspule (18) umfasst, wobei die eine oder mehreren weiteren Sensorspulen so vorgesehen und angepasst sind, dass ein magnetischer Fluss, der mit einem elektrischen Strom verbunden ist, der sich in einer vertikalen Richtung ausbreitet, eine erfassbare Spannung in der einen oder den mehreren weiteren Sensorspulen (18b) verursacht.

6. Halbleiteranordnung (16) nach Anspruch 5, wobei die Sensorspule (18) und die eine oder mehreren weiteren Sensorspulen (18b) elektrisch in Reihe geschaltet sind.

7. Halbleiteranordnung (16) nach einem der vorhergehenden Ansprüche, wobei die Sensorspule (18) laterale Metallisierungsstrukturen (15) und vertikale Durchkontaktierungen (21) umfasst.

8. Halbleiteranordnung (16) nach Anspruch 7, wobei die vertikalen Durchkontaktierungen (21) laterale Metallisierungsstrukturen (15) elektrisch verbinden, so dass ein, zwei oder mehr Segmente (S) oder Schichten (13) des dielektrischen Materials (5) zwischen den lateralen Metallisierungsstrukturen (15) angeordnet sind.

9. Halbleiteranordnung (16) nach einem der vorhergehenden Ansprüche, die ferner Folgendes umfasst:

- eine Kompensationsspule (2) mit einer Kompensationswicklung für jede Wicklung der Sensorspule, wobei die Kompensationsspule (2) vorgesehen und geeignet ist, eine Gleichtaktverzerrung der Sensorspule (18) zu kompensieren, wobei

- die Sensorspule (18) und die Kompensationsspule (2) eine differentielle Sensorstruktur (DSS) bilden.

10. Halbleiteranordnung (16) nach einem der vorhergehenden Ansprüche, die ferner eine Rückleitung der Spule umfasst, die so beschaffen und angepasst ist, dass sie eine störende Kopplung von nicht erwünschten Magnetfeldern minimiert.

11. Halbleiteranordnung (16) nach einem der vorhergehenden Ansprüche, ferner umfassend einen zweiten Strompfad (4b) in der negativen vertikalen Richtung (-z) und eine Hilfsspule (AC), die so ausgelegt und vorgesehen ist, dass ein magnetischer Fluss, der mit einem elektrischen Strom verbunden ist, der sich entlang des zweiten Strompfades (4b) in der negativen vertikalen Richtung ausbreitet, eine erfassbare Spannung in der Hilfsspule (AC) verursacht.

12. Halbleiteranordnung (16) nach einem der vorhergehenden Ansprüche, wobei der Strompfad (4) in der vertikalen Richtung elektrisch parallel geschaltete Abschnitte umfasst.

13. Halbleiteranordnung (16) nach einem der vorhergehenden Ansprüche, Kontakte (6, 9, 3) umfassend, die für eine Verbindung mit einer externen Schaltungsumgebung vorgesehen und geeignet sind, wobei die Kontakte (6, 9, 3)

- über die Oberseite (20) und die Unterseite (1) der Halbleiteranordnung verteilt sind,
- an der Oberseite (20) der Halbleiteranordnung (16) angeordnet sind, oder
- an der Unterseite (1) der Halbleiteranordnung (16) angeordnet sind.

14. Elektrisches Leistungsbauelement (7), das eine Halbleiteranordnung (16) nach einem der vorhergehenden Ansprüche umfasst, wobei das Bauelement (7) in einem Umrichter, einem Leistungselektronikumrichter oder einem Kraftfahrzeugwechselrichter eingesetzt wird.

15. Elektrisches Leistungsbauelement (7) nach Anspruch 14, das ferner eine mit der Sensorspule (18) gekoppelte integrierende Schaltung (12) umfasst.

16. Verwendung des elektrischen Leistungsbauelements (7) nach einem der Ansprüche 14 oder 15 für mindestens einen der folgenden Zwecke: Erfassung des Phasenstroms, Erkennung des Fehlerstroms, Bewertung des statischen Stromungleichgewichts, Bewertung des dynamischen Stromungleichgewichts, Stromregelung oder Stromüberwachung.

17. Verfahren zur Herstellung einer Halbleiteranordnung (16), das die folgenden Schritte umfasst:

- Bereitstellen eines Halbleiterelements (19),
- Einbetten des Halbleiterelements (19) in eine oder mehrere Schichten (13) aus dielektrischem Material (5),
- Erzeugen erster lateraler (15) und vertikaler (21) strukturierter Metallisierungen,
- Erzeugen von lateralen (15) und vertikalen (21) strukturierten Metallisierungen, um Wicklungen (22) einer Sensorspule (18) zu bilden, wobei die Sensorspule (18) so vorgesehen und angepasst ist, dass ein magnetischer Fluss, der mit einem zeitlich veränderlichen elektrischen Strom verbunden ist, der sich entlang eines Strompfades in einer vertikalen Richtung (z) ausbreitet, eine erfassbare Spannung in der Sensorspule (18) verursacht, wobei der Strompfad mit dem Halbleiterelement (19) verbunden ist,

wobei

- für die Herstellung der strukturierten Metallisierungen (15, 21) der Sensorspule (18) und für die Herstellung der ersten strukturierten Metallisierungen (15, 21) die gleichen Schritte, Verfahren und Materialien verwendet werden,
- die Wicklungen (22) in einer Ebene parallel zur vertikalen Richtung (z) angeordnet sind, **dadurch gekennzeichnet, dass**
- die Halbleiteranordnung (16) ein Chip - Scale - Package oder ein Chip-Scale-ähnliches Package oder ein Multichip-Chip-Scale-Package ist,
- die Grundfläche oder das Volumen des Package nicht größer ist als 200 Prozent der Grundfläche oder des Volumens des Chips oder nicht größer ist als 200 Prozent der Summe der Grundflächen oder Volumen der einzelnen Chips,
- die Sensorspule (18) eine spiralförmige Spule ist, die entlang eines Pfades angeordnet ist, der den Strompfad (4) seitlich umgibt,

- die Sensorspule (18) den Strompfad horizontal umgibt.

**Revendications**

1. Ensemble semi-conducteur (16), comprenant

   - un corps ayant une face inférieure (1) et une face supérieure (20) et une extension verticale allant de la face inférieure (1) à la face supérieure (20)
   - un élément semi-conducteur (19) disposé dans le corps,
   - une bobine de détection (18) disposée dans le corps, la bobine de détection ayant au moins un bobinage (22),
   - la bobine de détection (18) étant prévue et adaptée de telle sorte qu'un flux magnétique associé à un courant électrique variable dans le temps se propageant le long d'un chemin de courant dans une direction verticale (z) provoque une tension détectable dans la bobine de détection (18), ledit chemin de courant étant associé à l'élément semi-conducteur (19),
   - l'au moins un bobinage (22) étant disposé dans un plan parallèle à la direction verticale (z), **caractérisé en ce que**
   - l'ensemble semi-conducteur (16) est un boîtier de la taille d'une puce ou un boîtier de taille similaire à une puce ou un boîtier de la taille d'une puce à puces multiples,
   - l'empreinte ou le volume du boîtier ne dépasse pas 200 pour cent de l'empreinte ou le volume de la puce ou ne dépasse pas 200 pour cent de la sommes des empreintes ou volumes des puces individuelles,
   - la bobine de détection (18) est une bobine hélicoïdale disposée le long d'un chemin entourant latéralement le chemin de courant (4),
   - la bobine de détection (18) entoure horizontalement le chemin de courant.

2. Ensemble semi-conducteur (16) selon la revendication 1, comprenant en outre un ou plusieurs éléments semi-conducteurs additionnels (19b) de la forme de l'élément semi-conducteur (19), de telle sorte que l'ensemble semi-conducteur (16) soit un boîtier de taille similaire à une puce à puces multiples.

3. Ensemble semi-conducteur (16) selon l'une quelconque des revendications précédentes, dans lequel l'élément semi-conducteur (19) et l'au moins un bobinage (22) sont directement intégrés dans un matériau diélectrique (5).

4. Ensemble semi-conducteur (16) selon la revendication 3, dans lequel le matériau diélectrique (5) comprend un ou deux ou un plus grand nombre de segments (S) ou couches (13), chaque segment ou couche comprenant ou étant constitué d'un matériau ou une combinaison de matériaux, choisis parmi un matériau pour circuits imprimés, un matériau pour moules, un matériau thermoplastique, résine époxy, FR-2, papier phénolique, papier phénolique en coton, papier imprégné d'une résine phénol-formaldéhyde,
   FR-4, un tissu de fibre de verre imprégné d'une résine époxy, un polyimide, un polyimide-fluoropolymère, un composite polyimide-fluoropolymère, FR-1, FR-3, FR-5, une fibre de verre tissée, haute résistance à des températures plus élevées, FR-6, G-10, G-11, CEM-1, CEM-2, CEM-3, CEM-4, CEM-5, PTFE, RF-35, une céramique, de l'alumine.

5. Ensemble semi-conducteur (16) selon l'une quelconque des revendications précédentes, comprenant une ou plusieurs autres bobines de détection (18b) de la forme de la bobine de détection (18), la ou les autres bobines de détection étant prévues et adaptées de telle sorte qu'un flux magnétique associé à un courant électrique se propageant dans une direction verticale provoque une tension détectable dans la ou les autres bobines de détection (18b).

6. Ensemble semi-conducteur (16) selon la revendication 5, dans lequel la bobine de détection (18) et la ou les autres bobines de détection (18b) sont électriquement connectées en série.

7. Ensemble semi-conducteur (16) selon l'une quelconque des revendications précédentes, dans lequel la bobine de détection (18) comprend des structures de métallisation latérales (15) et des vias verticaux (21).

8. Ensemble semi-conducteur (16) selon la revendication 7, dans lequel les vias verticaux (21) connectent électriquement des structures de métallisation latérales (15) de telle sorte qu'un, deux ou un plus grand nombre de segments (S) ou couches (13) du matériau diélectrique (5) soient disposés entre les structures de métallisation latérales (15).

9. Ensemble semi-conducteur (16) selon l'une quelconque des revendications précédentes, comprenant en outre

- une bobine de compensation (2) ayant un enroulement de compensation pour chaque enroulement de la bobine de détection, la bobine de compensation (2) étant prévue et adaptée pour compenser une distorsion en mode commun de la bobine de détection (18),
- la bobine de détection (18) et la bobine de compensation (2) établissant une structure de détection différentielle (DSS) .

10. Ensemble semi-conducteur (16) selon l'une quelconque des revendications précédentes, comprenant en outre une ligne de retour de la bobine prévue et adaptée pour minimiser le couplage parasite avec des champs magnétiques non désirés.

11. Ensemble semi-conducteur (16) selon l'une quelconque des revendications précédentes, comprenant en outre un deuxième chemin de courant (4b) dans la direction verticale négative (-z) et une bobine auxiliaire (AC) adaptée et prévue de telle sorte qu'un flux magnétique associé à un courant électrique se propageant le long du deuxième chemin de courant (4b) dans la direction verticale négative provoque une tension détectable dans la bobine auxiliaire (AC).

12. Ensemble semi-conducteur (16) selon l'une quelconque des revendications précédentes, dans lequel le chemin de courant (4) dans la direction verticale comprend des sections électriquement connectées en parallèle.

13. Ensemble semi-conducteur (16) selon l'une quelconque des revendications précédentes, comprenant des contacts (6, 9, 3) prévus et adaptés pour une connexion à un environnement de circuit externe, les contacts (6, 9, 3) étant

   - distribués sur la face supérieure (20) et la face inférieure (1) de l'ensemble semi-conducteur,
   - disposés sur la face supérieure (20) de l'ensemble semi-conducteur (16) ou
   - disposés sur la face inférieure (1) de l'ensemble semi-conducteur (16).

14. Dispositif de puissance électrique (7), comprenant un ensemble semi-conducteur (16) selon l'une quelconque des revendications précédentes, le dispositif (7) étant appliqué dans un convertisseur, un convertisseur d'électronique de puissance, ou un inverseur d'automobile.

15. Dispositif de puissance électrique (7) selon la revendication 14, comprenant en outre un circuit d'intégration (12) couplé à la bobine de détection (18).

16. Utilisation du dispositif de puissance électrique (7) selon l'une quelconque des revendications 14 ou 15 pour au moins l'une des opérations suivantes : détection de courant de phase, détection de courant de défaut, évaluation du déséquilibre statique du courant, évaluation du déséquilibre dynamique du courant, contrôle du courant ou surveillance du courant.

17. Procédé de fabrication d'un ensemble semi-conducteur (16), comprenant les étapes de :

   - fourniture d'un élément semi-conducteur (19),
   - intégration de l'élément semi-conducteur (19) dans une ou plusieurs couches (13) de matériau diélectrique (5),
   - création de premières métallisations structurées latérales (15) et verticales (21),
   - création de métallisations structurées latérales (15) et verticales (21) pour établir des bobinages (22) d'une bobine de détection (18), la bobine de détection (18) étant prévue et adaptée de telle sorte qu'un flux magnétique associé à un courant électrique variable dans le temps se propageant le long d'un chemin de courant dans une direction verticale (z) provoque une tension détectable dans la bobine de détection (18), ledit chemin de courant étant associé à l'élément semi-conducteur (19),

   où

   - pour la création des métallisations structurées (15, 21) de la bobine de détection (18) et pour la création des premières métallisations structurées (15, 21) les mêmes étapes, processus et matériaux sont utilisés,
   - les bobinages (22) sont disposés dans un plan parallèle à la direction verticale (z), **caractérisé en ce que**
   - l'ensemble semi-conducteur (16) est un boîtier de la taille d'une puce ou un boîtier de taille similaire à une puce ou un boîtier de la taille d'une puce à puces multiples,
   - l'empreinte ou le volume du boîtier ne dépasse pas 200 pour cent de l'empreinte ou le volume de la puce ou ne dépasse pas 200 pour cent de la sommes des empreintes ou volumes des puces individuelles,

- la bobine de détection (18) est une bobine hélicoïdale disposée le long d'un chemin entourant latéralement le chemin de courant (4),
- la bobine de détection (18) entoure horizontalement le chemin de courant.

Fig. 1

Fig. 2

Fig. 3

Fig. 4

18

y

x

2

Fig. 5

16

18

18

z

x

Fig. 6

19

Fig. 7

Fig. 8

16

9

y

x

18

Fig. 9

16, 17

6

18

18

6

9

y

x

Fig. 10

Fig. 11

Fig. 12

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 3012846 A1
- US 2017271260 A1
- US 2001023530 A1
- US 2003013264 A1
- US 2015028487 A1